# EUROPÄISCHE PATENTSCHRIFT

(11) **EP 3 289 839 B1**
(45) Veröffentlichungstag und Bekanntmachung des Hinweises auf die Patenterteilung: **09.12.2020**
(21) Anmeldenummer: 16707437.6
(22) Anmeldetag: 02.03.2016
(51) Int. Cl.: H05K 5/00, H05K 7/20

(54) **ELEKTRONISCHE BAUGRUPPE, INSBESONDERE FÜR EIN GETRIEBESTEUERMODUL**
ELECTRONIC ASSEMBLY, IN PARTICULAR FOR A TRANSMISSION CONTROL MODULE
MODULE ÉLECTRONIQUE, EN PARTICULIER POUR UN MODULE DE COMMANDE DE TRANSMISSION

(30) Priorität: 29.04.2015 DE 102015207867
(43) Veröffentlichungstag der Anmeldung: 07.03.2018
(73) Patentinhaber: Robert Bosch GmbH, 70442 Stuttgart (DE)
(72) Erfinder: LISKOW, Uwe, 71679 Asperg (DE)
(86) Internationale Anmeldenummer: PCT/EP2016/054384
(87) Internationale Veröffentlichungsnummer: WO 2016/173747

(56) Entgegenhaltungen:
- EP-A2- 0 902 611
- DE-A1-102012 222 180

## Beschreibung

### Stand der Technik

Die Erfindung betrifft eine elektronische Baugruppe, insbesondere für ein Getriebesteuermodul, mit den Merkmalen des Oberbegriffs des unabhängigen Anspruchs 1.

In der Kraftfahrzeugtechnik werden zur Getriebeansteuerung am Getriebe verbaute elektronische Steuermodule verwendet. Die Steuermodule können Aktuatoren, Sensoren, Stecker, wenigstens ein gekapseltes Steuergerät (TCU, Transmission Control Unit) und weitere Komponenten aufweisen. Das gekapselte Steuergerät bildet eine elektronische Baugruppe. Um die von elektrischen oder elektronischen Bauelementen der elektronischen Baugruppe abgegebene Wärme möglichst gut abzuleiten, ist es bekannt, die elektronischen Baugruppen mit einem Kühlkörper zu versehen.

Elektrische oder elektronische Bauelemente können sehr empfindlich gegenüber Belastungen wie etwa einem Angriff durch Fluide wie beispielsweise Getriebeöle sein. Um elektrische oder elektronische Bauelemente vor derartigen Belastungen zu schützen, ist es bekannt, über den Bauelementen auf der Leiterplatte eine Schutzabdeckung aufzubringen, welche die Bauelemente nach außen dichtend abdeckt und sie so vor den Belastungen schützt. Die Schutzabdeckung kann beispielsweise einen Gehäusedeckel, einen Verguss, einen Lack oder eine Moldmasse umfassen. So zeigt beispielsweise die gattungsbildende DE 197 01 731 A1 ein Gehäuse für eine als Steuermodul ausgebildete elektronische Baugruppe, wobei eine beidseitig mit Bauelementen bestückte Leiterplatte an Stellen, an denen sie mit wärmeerzeugenden Bauelementen bestückt ist, auf einem aus wärmeleitendem Material bestehenden und als Kühlkörper dienenden Gehäuseteil aufliegt. Die elektrischen und elektronischen Bauelemente werden durch einen mechanisch befestigten Gehäusedeckel abgedeckt.

Die DE 10 2012 209 034 A1 zeigt beispielsweise eine elektronische Baugruppe mit einer aus Moldmasse bestehenden Schutzabdeckung, in der auch ein Kühlkörper angeordnet ist.

Weitere Beispiele sind aus DE 10 2012 222180 A1 und EP0902611 A2 vorbekannt.

### Offenbarung der Erfindung

Erfindungsgemäß wird eine elektronische Baugruppe, insbesondere für ein Getriebesteuermodul, gemäß Anspruch 1 vorgeschlagen. Diese umfasst eine Leiterplatte mit einer ersten Seite und einer von der ersten Seite abgewandten zweiten Seite und mit wenigstens einem auf der ersten Seite der Leiterplatte angeordneten wärmeerzeugenden Bauelement, wobei die elektronische Baugruppe weiterhin einen Kühlkörper umfasst, der eine der zweiten Seite der Leiterplatte zugewandte Innenfläche aufweist, wobei die Innenfläche des Kühlkörpers zumindest abschnittsweise von der Leiterplatte durch wenigstens einen Spalt beabstandet ist. Erfindungsgemäß ist das wenigstens eine wärmeerzeugende Bauelement mit einer fließfähigen und aushärtbaren Schutzmasse abgedeckt und der wenigstens eine Spalt zumindest teilweise mit der wenigstens einen fließfähigen und aushärtbaren Schutzmasse derart gefüllt, dass die fließfähige und aushärtbare Schutzmasse in direktem Kontakt zur Leiterplatte und zum Kühlkörper steht und der Kühlkörper im ausgehärteten Zustand der fließfähigen und aushärtbaren Schutzmasse stoffschlüssig an der Schutzmasse anhaftet.

### Vorteile der Erfindung

Gegenüber dem Stand der Technik weist die elektronische Baugruppe mit den Merkmalen des unabhängigen Anspruchs den Vorteil auf, dass die fließfähige und aushärtbare Schutzmasse einerseits die elektrischen und/oder elektronischen Bauelemente auf der Leiterplatte vorteilhaft dichtend abdeckt und dadurch vor Belastungen, beispielsweise mechanischen Belastungen oder, wie bei einer Anwendung im Getriebeöl, vor dem Angriff des umliegenden Mediums schützen kann und gleichzeitig dazu dient, die Leiterplatte an dem Kühlkörper zu befestigen, wobei ein Spalt zwischen dem Kühlkörper und der Leiterplatte beispielsweise durch Epoxiharzmasse, die sowohl am Kühlkörper als auch der Leiterplatte haftet, ausgespritzt oder ausgegossen ist und damit auf einfache und kostengünstige Art und Weise die Leiterplatte mit dem Kühlkörper verbunden ist. Vorteilhaft kann der Spalt zur Anordnung von Bauelementen auf der dem Kühlkörper zugewandten zweiten Seite der Leiterplatte genutzt werden. Darüber hinaus kann die Schutzmasse unterstützend zur Ableitung der durch die Bauelemente erzeugten Wärme beispielsweise über Vias durch die Leiterplatte und in Richtung des Kühlkörpers und, auf der ersten Seite der Leiterplatte, in Richtung des Außenbereiches der elektronischen Baugruppe, beispielsweise in Richtung eines umgebenden Getriebeöles, beitragen. Darüber hinaus kann die Leiterplatte besonders vorteilhaft und kostengünstig in Standardprozessen ohne spezielle Bauelemente für beispielsweise Slug-up-Entwärmung, bei der die Wärme über Abstandsplatten und Entwärmplatten an einen über der Leiterplatte angeordneten Kühlkörper abgeleitet wird, bestückt werden.

Weitere vorteilhafte Ausgestaltungen und Weiterbildungen der Erfindungen werden durch die in den Unteransprüchen angegebenen Merkmale ermöglicht.

Vorteilhaft kann die Innenfläche des Kühlkörpers wenigstens eine Absenkung aufweisen, die umlaufend von wenigstens einem Wall umgeben ist. So kann die Leiterplatte direkt auf dem Wall des Kühlkörpers aufliegen und gleichzeitig die fließfähige und aushärtbare Masse in die Absenkung derart eingebracht sein, dass sie stoffschlüssig an der Leiterplatte und an dem Kühlkörper anhaftet und diese vorteilhaft miteinander verbindet.

Durch die an der Innenfläche des Kühlkörpers ausgebildete Absenkung sind vorteilhaft nicht nur auf der ersten Seite der Leiterplatte sondern auch auf der zweiten Seite der Leiterplatte weitere elektrische oder elektronische Bauelemente angeordnet, so dass diese weiteren elektrischen und elektronischen Bauelemente innerhalb der Absenkung angeordnet sind. Durch die Anbringung elektrischer und elektronischer Bauelemente auf der zweiten Seite der Leiterplatte kann die Anzahl der Bauelemente auf der ersten Seite der Leiterplatte und damit die Fläche der Leiterplatte reduziert werden. Die Leiterplatte kann somit näher auf den Kühlkörper aufgebracht werden und damit die Gesamthöhe der elektronischen Baugruppe reduziert werden.

Erfindungsgemäß steht die Leiterplatte über Auflageflächen des Walls in direktem Kontakt mit dem Kühlkörper, so dass die auf der Leiterplatte von den wärmeerzeugenden Bauelementen erzeugte Wärme effektiv an den Kühlkörper abgeleitet werden kann. Ist die Absenkung derart ausgebildet, dass sie umlaufend von einer Auflagefläche umgeben ist, hat dies den Vorteil, dass die Leiterplatte stabil und sicher auf dem Kühlkörper aufliegen kann.

Die Leiterplatte kann auch durch einen schmalen Zwischenraum von dem Wall beabstandet sein, beispielsweise in einem Abstand von 50 Mikrometern bis zu einem Millimeter. Durch den geringen Zwischenraum kann die, durch die an der ersten Seite der Leiterplatte angeordneten Bauelemente erzeugte, Wärme vorteilhaft an den Kühlkörper abgeleitet werden.

Der Zwischenraum zwischen dem Wall und der Leiterplatte kann beispielsweise vorteilhaft mit der fließfähigen und aushärtbaren Schutzmasse ausgefüllt sein, so dass die auf der Leiterplatte erzeugte Wärme über einen geringen thermischen Widerstand der Schutzmasse an den Kühlkörper abgeleitet werden kann. Darüber hinaus können vorteilhaft weitere Teile der zweiten Seite der Leiterplatte mit weiteren Teilen der Innenfläche des Kühlkörpers über die fließfähige und aushärtbare Schutzmasse verbunden werden, was zusätzliche Stabilität der Verbindung zwischen der Leiterplatte und dem Kühlkörper und zusätzlichen Schutz der auf der Leiterplatte angeordneten Bauelemente gewährleisten kann.

Erfindungsgemäß ist vorgesehen, dass der Wall direkt unterhalb der wärmeerzeugenden Bauelemente angeordnet ist, so dass der Abstand zwischen den wärmeerzeugenden Bauelementen und dem Kühlkörper möglichst gering ist und somit die durch die Bauelemente auf der Leiterplatte erzeugte Wärme besonders effektiv beispielsweise durch Vias an den Kühlkörper abgeleitet werden kann. Es kann sich als Vorteil erweisen, wenn direkt unterhalb der auf der ersten Seite der Leiterplatte angeordneten wärmeerzeugenden Bauelemente auf der zweiten Seite der Leiterplatte wärmeleitende Wärmeleitschichten angeordnet sind. Über diese kann ein guter thermischer Kontakt zwischen den wärmeerzeugenden Bauelementen auf der Leiterplatte und dem Wall des Kühlkörpers hergestellt werden, was sich als besonders vorteilhaft erweist, wenn der Wall des Kühlkörpers nicht oder nur teilweise direkt unterhalb der wärmeerzeugenden Bauelemente angeordnet ist.

Wenn die Leiterplatte nur auf der ersten Seite mit Bauelementen bestückt ist, kann es sich als Vorteil erweisen, wenn die gesamte Innenfläche des Kühlkörpers ohne Absenkung, also beispielsweise eben ausgebildet ist, so dass die zweite Seite der Leiterplatte durchgehend durch einen Spalt von der Innenfläche des Kühlkörpers beabstandet ist, wobei der Spalt eine Breite ausweist, die in dem gesamten Spalt beispielsweise zwischen fünfzig Millimetern und einem Millimeter beträgt. Ist der Spalt besonders vorteilhaft komplett mit der fließfähigen und aushärtbaren Schutzmasse gefüllt, wird gewährleistet, dass die Leiterplatte besonders sicher am Kühlkörper befestigt ist und besonders stabil auf diesem aufliegt.

Um die Baugruppe zusätzlich zu schützen und die Stabilität der Baugruppe zu erhöhen, ist es besonders vorteilhaft, wenn die die wärmeerzeugenden Bauelemente abdeckende Schutzmasse mit der den Kühlkörper und die Leiterplatte verbindenden Schutzmasse einteilig ausgebildet.

Die die wärmeerzeugenden Bauelemente abdeckende Schutzmasse kann beispielsweise besonders vorteilhaft und einfach mit der den Kühlkörper und die Leiterplatte verbindenden Schutzmasse durch einen oder mehrere Durchbrüche in der Leiterplatte verbunden und somit einteilig ausgebildet sein.

### Kurze Beschreibung der Zeichnungen

Ausführungsbeispiele der Erfindung sind in der Zeichnung dargestellt und werden in der nachfolgenden Beschreibung näher erläutert. Es zeigen
Fig. 1 einen schematischen Querschnitt durch ein erstes Ausführungsbeispiel der erfindungsgemäßen elektronischen Baugruppe,
Fig. 2 eine Draufsicht auf eine beispielhaft dargestellte Leiterplatte,
Fig. 3 eine Draufsicht auf einen beispielhaft dargestellten Kühlkörper,
Fig. 4 eine schematische Überlagerung von Fig. 2 und Fig. 3,
Fig. 5 eine Seitenansicht des ersten Ausführungsbeispiels,
Fig. 6 eine Seitenansicht eines zweiten Ausführungsbeispiels,
Fig. 7 eine Seitenansicht eines dritten Ausführungsbeispiels.

### Ausführungsformen der Erfindung

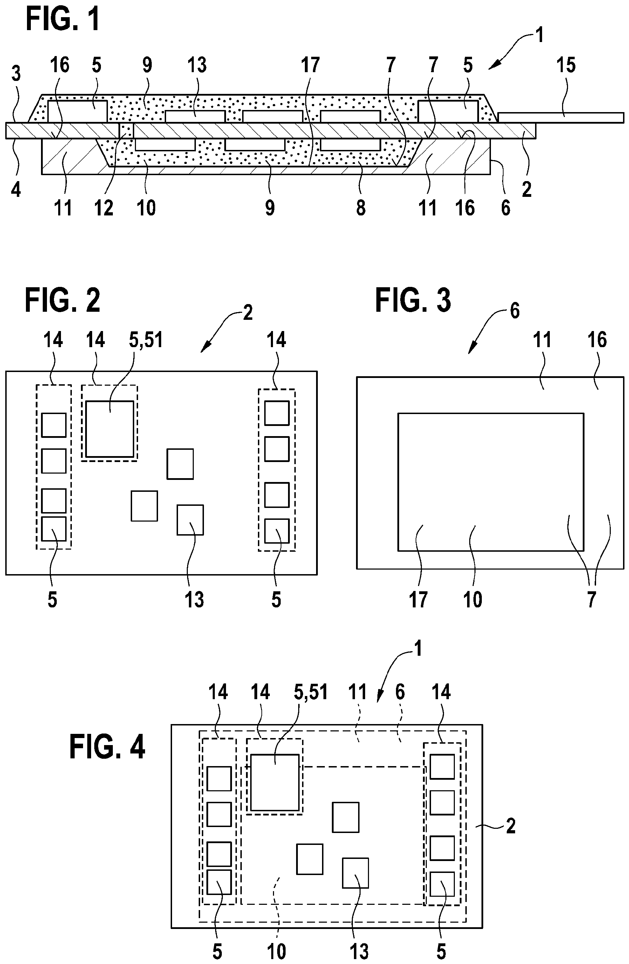

Fig. 1 zeigt einen schematischen Querschnitt durch ein erstes Ausführungsbeispiel der elektronischen Baugruppe 1, welche Teil eines Getriebesteuermoduls sein kann, das beispielsweise an einem oder in einem Kraftfahrzeuggetriebe verbaut werden kann. Die elektronische Baugruppe 1 umfasst eine Leiterplatte 2, die auf der ersten Seite 3 mit wenigstens einem wärmeerzeugenden Bauelement 5 bestückt ist, und einen Kühlkörper 6. Eine Innenfläche 7 des Kühlkörpers 6 ist einer von der ersten Seite 3 der Leiterplatte 2 abgewandten zweiten Seite 4 der Leiterplatte 2 zugewandt und durch einen Spalt 8 zumindest abschnittsweise von dieser beabstandet.

In diesem Beispiel handelt es sich bei der Leiterplatte 2 beispielsweise um eine Leiterplatte in FR4-Ausführung oder höherwertig, also beispielsweise um eine Leiterplatte aus glasfaserverstärktem Epoxidharz. Die Leiterplatte 2 kann aber auch eine HDI-Leiterplatte (High Density Interconnect-Leiterplatte), eine LTCC (Low Temperature Cofired Ceramics) oder eine andere geeignete Leiterplatte sein. Auf der ersten Seite 3 der Leiterplatte 2 sind ein oder mehrere, miteinander durch Leiterbahnen verbundene, wärmeerzeugende Bauelemente 5 angeordnet. Es kann sich um ein einzelnes wärmeerzeugendes Bauelement 5 oder mehrere über Leiterbahnen der Leiterplatte 2 elektrisch verbundene und eine Steuerschaltung bildende elektrische und/oder elektronische Bauelemente handeln, insbesondere um aktive Bauelemente wie beispielsweise IC-Chips, Transistoren oder ASICs. Die Leiterplatte 2 kann über ein oder mehrere elektrische Anschlusselemente 15, beispielsweise flexible elektrische Leiterplatten (FPC = Flexible Printed Circuit Board), Kabel oder Stanzgitter, mit anderen außerhalb der elektronischen Baugruppe 1 vorhandenen und in Fig. 1 nicht abgebildeten elektrischen oder elektronischen Komponenten, beispielsweise Sensoren, Aktuatoren und Steckerteilen, elektrisch kontaktiert sein. Neben dem wenigstens einem wärmeerzeugenden Bauelement 5 können auf der ersten Seite 3 und/oder auf der zweiten Seite 4 der Leiterplatte 2 auch ein oder mehrere weitere elektrische und/oder elektronische nicht wärmeerzeugende Bauelemente 13 angeordnet sein, die über Leiterbahnen der Leiterplatte 2 untereinander und/oder mit einem oder mehreren wärmeerzeugenden Bauelementen 5 elektrisch verbunden sein und eine Steuerschaltung bilden. Die Bauelemente 13 können beispielsweise passive Bauelemente sein.

In diesem Beispiel werden die auf der ersten Seite 3 der Leiterplatte 2 angeordneten wärmeerzeugenden und nicht wärmeerzeugenden Bauelemente 5,13 durch eine fließfähige und aushärtbare Schutzmasse 9 abgedeckt und somit beispielsweise vor mechanischen Belastungen oder dem Angriff fluider Medien wie beispielsweise Getriebeöl geschützt. Die fließfähige und aushärtbare Schutzmasse 9 kann wie in Fig. 1 dargestellt einteilig ausgebildet sein und alle auf der ersten Seite 3 der Leiterplatte 2 angeordneten Bauelemente 5,13 unter einer gemeinsamen Schutzabdeckung dichtend abdecken. Sie kann aber beispielsweise auch mehrteilig ausgebildet sein und einzelne oder Gruppen von auf der ersten Seite 3 der Leiterplatte 2 angeordneten Bauelementen 5,13 dichtend abdecken. In diesem Beispiel ist die fließfähige und aushärtbare Schutzmasse 9, die auch die Bauelemente 5,13 auf der ersten Seite 3 der Leiterplatte 2 dichtend abdeckt, in einem Spalt 8 zwischen der zweiten Seite 4 der Leiterplatte 2 und der Innenfläche 7 des Kühlkörpers 6, eingebracht, um die an der zweiten Seite 4 der Leiterplatte 2 angeordneten weiteren elektrischen und/oder elektronischen Bauelemente 13 abzudecken und gleichzeitig den Kühlkörper 6 mit der Leiterplatte 2 zu verbinden. In diesem Ausführungsbeispiel weist die Innenfläche 7 eine Absenkung 10 auf, die derart ausgebildet ist, dass sie einen vom einem Wall 11 imgebenen Grund aufweist, wobei der der Spalt 8 durch den Abstand des Grundes 17 der Absenkung 10 und der zweiten Seite 4 der Leiterplatte 2 gebildet wird. Die Absenkung 10 kann wie in Fig. 1 dargestellt vollständig mit der fließfähigen und aushärtbaren Schutzmasse 9 ausgefüllt sein. Die Absenkung 10 kann aber auch nur teilweise mit der fließfähigen und aushärtbaren Schutzmasse 9 ausgefüllt sein.

Unter einer fließfähigen und aushärtbaren Schutzmasse 9 wird im Kontext der vorliegenden Anmeldung ein fließfähiger und flüssiger Stoff verstanden, der durch einen Aushärteprozess erstarrt, wobei der Stoff im ausgehärteten Zustand stoffschlüssig an das Material der Leiterplatte 2 und an das Material des Kühlkörpers 6 anhaftet. Die fließfähige und aushärtbare Schutzmasse 9 haftet dabei beispielsweise an der zweiten Seite 4 der Leiterplatte 2 und an der Innenfläche 7 des Kühlkörpers 6 an. Die fließfähige und aushärtbare Schutzmasse 9 kann beispielsweise ein polymeres Schutzsystem sein und beispielsweise durch Umspritzung oder Verguss aufgebracht werden. Insbesondere kann es sich um ein Duroplast handeln.

Der Kühlkörper 6 kann beispielsweise aus einem wärmeleitenden Material wie Aluminium oder aus wärmeleitendem Kunststoff bestehen. In diesem Ausführungsbeispiel ist der Kühlkörper 6 derart ausgebildet, dass er in einem Bereich direkt unterhalb des wenigstens einen wärmeerzeugenden Bauelementes 5 eine Auflagefläche 16 auf dem Wall 11 aufweist, auf der die Leiterplatte 2 in direktem Kontakt mit der Innenfläche 7 des Kühlkörpers 6 steht und dadurch die von den wärmeerzeugenden Bauelementen 5 erzeugte Wärme über die Leiterplatte 2 insbesondere über thermische Vias in der Leiterplatte 2 an den Kühlkörper 6 abgeleitet werden kann. Des weiteren sind in diesem Ausführungsbeispiel auf der zweiten Seite 4 der Leiterplatte 2 weitere Bauelemente 13 in der Absenkung 10 angeordnet, so dass die Leiterplatte 2 auf die Auflagefläche 16 an der Innenfläche 7 des Kühlkörpers 6 aufgelegt werden kann. Der Abstand zwischen dem umlaufend von dem Wall 11 umgebenen Grund 17 der Absenkung 10 und der zweiten Seite 4 der Leiterplatte 2 bildet dabei den wenigstens teilweise mit der wenigstens einen fließfähigen und aushärtbaren Schutzmasse 9 gefüllten Spalt 8.

In der Leiterplatte 2 können ein oder mehrere Durchbrüche 12 ausgebildet sein, durch die die wärmeerzeugenden Bauelemente 5 abdeckende fließfähige und aushärtbare Schutzmasse 9 mit der im Spalt 8 befindlichen fließfähigen und aushärtbaren Schutzmasse 9 einteilig verbunden sein kann. Beispielsweise kann während des Fertigungsprozesses die noch nicht ausgehärtete Schutzmasse 9 durch den Durchbruch 12 der Leiterplatte 2 in den Spalt 8 fließen. So kann in einem Arbeitsschritt der Spalt 8 mit der fließfähigen und aushärtbaren Schutzmasse 9 gefüllt werden und gleichzeitig die wärmeerzeugenden Bauelemente 5 auf der ersten Seite 3 der Leiterplatte 2 durch die fließfähige und aushärtbare Schutzmasse 9 abgedeckt werden.

Fig. 2 zeigt eine Draufsicht auf eine beispielhaft dargestellte Leiterplatte 2 des ersten Ausführungsbeispiels. Diese umfasst beispielsweise auf der ersten Seite 3 der Leiterplatte 2 angeordnete wärmeerzeugende Bauelemente 5 und ein oder mehrere auf der ersten Seite 3 und/oder auf der zweiten Seite 4 der Leiterplatte 2 angeordnete weitere Bauelemente 13. Zusätzlich sind auf der zweiten Seite 4 der Leiterplatte 2 Wärmeleitschichten 14, die beispielsweise als Metallisierungen ausgebildet sein können, angeordnet. Es kann sich um eine einzelne zusammenhängende Wärmeleitschicht 14 oder um mehrere nicht zusammenhängende Wärmeleitschichten 14 handeln. Die ein oder mehreren Wärmeleitschichten 14 sind auf der zweiten Seite 4 der Leiterplatte 2 zumindest teilweise direkt unterhalb der auf der ersten Seite 3 der Leiterplatte 2 angeordneten wärmeerzeugenden Bauelemente 5 angeordnet.

Im Kontext der vorliegenden Anmeldung ist ein Objekt ein wärmeerzeugendes Bauelement 5, ein nicht wärmeerzeugendes Bauelement 13, eine Wärmeleitschicht 14 oder ein Wall 11. Ist ein auf der zweiten Seite 4 der Leiterplatte 2 angeordnetes erstes Objekt teilweise direkt unterhalb oder oberhalb eines auf der ersten Seite 3 der Leiterplatte 2 angeordneten zweiten Objektes angeordnet, so wird im Kontext der vorliegenden Anmeldung darunter verstanden, dass das erste Objekt und das zweite Objekt an der Leiterplatte relativ zueinander derart angeordnet sind, dass eine senkrechte Projektion des ersten Objekts auf eine Seite 3, 4 der Leiterplatte 2 zumindest teilweise innerhalb einer senkrechten Projektion des zweiten Objekts auf die gleiche Seite 3, 4 der Leiterplatte 2 liegt.

Fig. 3 zeigt eine Draufsicht auf die Innenfläche 7 eines beispielhaft dargestellten, an die beispielhaft in Fig. 2 dargestellte Leiterplatte 2 angepassten Kühlkörpers 6. An dem beispielhaft dargestellten Kühlkörper 6 ist ein Wall 11 mit einer Auflagefläche 16 ausgebildet, auf den eine Leiterplatte 2 aufgelegt werden kann. Desweiteren ist in diesem Ausführungsbeispiel in der Innenfläche 7 des Kühlkörpers 6 eine Absenkung 10 ausgebildet, deren Grund 17 eine ebene Fläche bildet und umlaufend von dem Wall 11 umgeben ist. Auf der Innenfläche 7 des Kühlkörpers 6 können aber auch mehrere Absenkungen 10, die von einem zusammenhängenden Wall 11 oder mehreren Wällen 11 umgeben sind und in denen einzelne weitere Bauelemente 13 oder Gruppen von weiteren Bauelementen 13 angeordnet sein können, ausgebildet sein.

Fig. 4 zeigt eine schematische Überlagerung von Fig. 2 und Fig. 3. Die beispielhaft dargestellte Leiterplatte 2 liegt mit ihrer zweiten Seite 4 auf der Auflagefläche 16 des Walls 11 auf der Innenfläche 7 des Kühlkörpers 6 auf. In diesem Anwendungsbeispiel ist der Kühlkörper 6 derart geformt, dass die Auflagefläche 16 des Walls 11, wenn die Leiterplatte 2 auf dem Kühlkörper 6 aufliegt, zumindest teilweise direkt unterhalb der auf der ersten Seite 3 der Leiterplatte 2 angeordneten wärmeerzeugenden Bauelemente 5 liegt und somit eine gute Wärmeableitung von den wärmeerzeugenden Bauelementen 5 über die Leiterplatte 2 an den Kühlkörper 6 gewährleistet ist. Befindet sich, wie beispielhaft in Fig. 4 an einem wärmeerzeugenden Bauelement 51 gezeigt, das wärmeerzeugende Bauelement 51 nur teilweise direkt oberhalb der Auflagefläche 16 des Walls 11 des Kühlkörpers 6, so kann beispielsweise über eine auf der zweiten Seite 4 der Leiterplatte 2 angeordnete Wärmeleitschicht 14 beispielsweise durch Vias in der Leiterplatte 2 ein guter thermischer Kontakt zwischen dem wärmeerzeugenden Bauelement 5, der Wärmeleitschicht 14 und der Auflagefläche 16 des Walls 11 des Kühlkörpers 6 hergestellt werden. Befindet sich der Wall 11 beispielsweise auch nicht einmal teilweise direkt unterhalb eines wärmeerzeugenden Bauelements 5, so kann beispielsweise über eine Wärmeleitschicht 14 ein thermischer Kontakt zwischen dem wärmeerzeugenden Bauelement 5 und dem Kühlkörper 6 hergestellt werden. Im Inneren der auf der Innenfläche 7 des Kühlkörpers 6 angeordneten Absenkung 10 können ein oder mehrere weitere Bauelemente 13 beispielsweise auch auf der zweiten Seite 4 der Leiterplatte 2 angeordnet werden und die zweite Seite 4 der Leiterplatte 2 gleichzeitig über die Auflagefläche 16 in direktem Kontakt mit der Innenfläche 7 des Kühlkörpers 6 stehen.

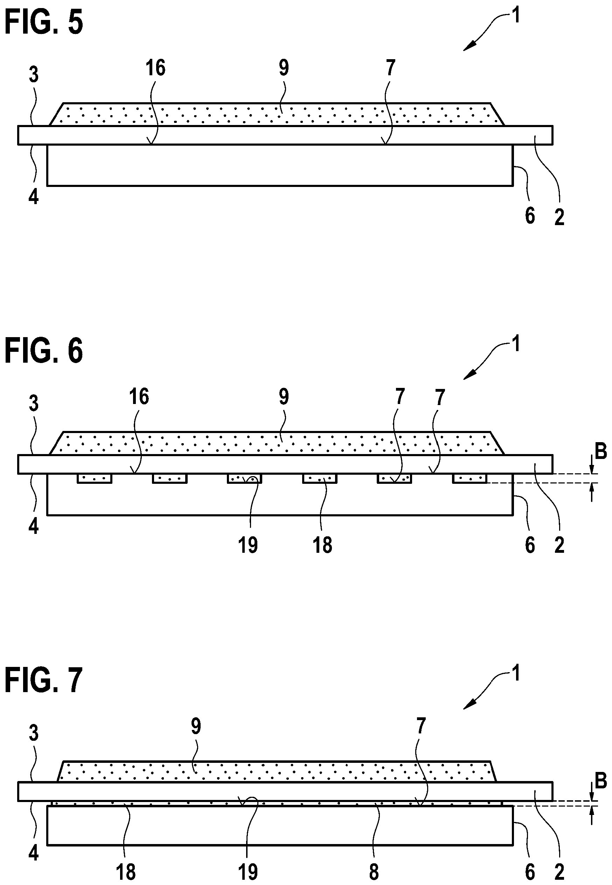

Fig. 5 zeigt eine Seitenansicht des ersten Ausführungsbeispiels. Das elektrische Anschlusselement 15 ist in Fig. 5 nicht dargestellt. Auf der ersten Seite 3 der Leiterplatte 2 ist die fließfähige und aushärtbare Schutzmasse 9 aufgetragen, so dass die nicht abgebildeten, auf der ersten Seite 3 der Leiterplatte 2 angeordneten, wärmeerzeugenden Bauelemente 5 nach außen dichtend bedeckt sind. Die zweite Seite 4 der Leiterplatte 2 liegt in diesem Ausführungsbeispiel auf der Auflagefläche 16 des Walls 11 auf dem Kühlkörper 6 auf und steht so in direktem thermischem Kontakt mit der Auflagefläche 16 des Kühlkörpers 6. Zwischen der Auflagefläche 16 des Kühlkörpers 6 und der zweiten Seite 4 der Leiterplatte 2 befindet sich keine fließfähige und aushärtbare Schutzmasse 9. Die den Kühlkörper 6 und die Leiterplatte 2 verbindende fließfähige und aushärtbare Schutzmasse 9 ist in der, in der Seitenansicht nicht dargestellten, Absenkung 10 angeordnet, wie in Fig. 1 erkennbar ist.

Fig. 6 zeigt eine Seitenansicht eines zweiten Ausführungsbeispiels der elektronischen Baugruppe 1, bei dem im Unterschied zum ersten Ausführungsbeispiel die Auflagefläche 16 des Walls 11 nicht einteilig und die Absenkung 10 vollständig umlaufend, sondern mehrteilig ausgebildet ist, wobei der Wall 11 zusätzlich zu den Auflageflächen 16 auch der zweiten Seite 4 der Leiterplatte 2 zugewandte Abstandsflächen 19 aufweist, an denen der Wall 11 durch Zwischenräume 18 mit einem Abstandsmaß B von der zweiten Seite 4 der Leiterplatte 2 beabstandet ist. Die Zwischenräume können beispielsweise mit einer dünnen Schicht der fließfähigen und aushärtbaren Schutzmasse 9 gefüllt sein und so der Wall 11 mit der zweiten Seite 4 der Leiterplatte 2 verbunden sein. Auch in diesem zweiten Ausführungsbeispiel kann die den Kühlkörper 6 und die Leiterplatte 2 verbindende fließfähige und aushärtbare Schutzmasse 9 zusätzlich in einer, in der Seitenansicht nicht dargestellten, Absenkung 10 angeordnet sein, wie in Fig. 1 anhand des ersten Ausführungsbeispiels erläutert ist.

Fig. 7 zeigt ein drittes Ausführungsbeispiel der elektronischen Baugruppe 1, bei dem die Leiterplatte 2 über eine Schicht fließfähiger und aushärtbarer Schutzmasse 9 von beispielsweise 50 Mikrometern bis zu einem Millimeter mit dem Kühlkörper 6 verbunden ist. Die Schicht fließfähiger und aushärtbarer Schutzmasse 9 ist in einem Zwischenraum 18, der die zweite Seite 4 der Leiterplatte 2 von dem Wall 11 beabstandet, angeordnet. Auch im dritten Ausführungsbeispiel kann die den Kühlkörper 6 und die Leiterplatte 2 verbindende fließfähige und aushärtbare Schutzmasse 9 zusätzlich in einer, in der Seitenansicht nicht dargestellten, Absenkung 10 angeordnet sein, wie in Fig. 1 anhand des ersten Ausführungsbeispiels erläutert ist.

In einem vierten Ausführungsbeispiel ist die zweite Seite 4 der Leiterplatte 2 durchgehend durch einen Spalt 8 von der Innenfläche 7 des Kühlkörpers 6 beabstandet, wobei der Spalt 8 eine Breite ausweist, die in dem gesamten Spalt 8 beispielsweise zwischen fünfzig Millimetern und einem Millimeter beträgt. Der Spalt 8 ist im vierten Ausführungsbeispiel wenigstens teilweise mit der fließfähigen und aushärtbaren Schutzmasse 9 gefüllt. In dem vierten Ausführungsbeispiel ist im Unterschied zu den vorhergehenden Ausführungsbeispielen am Kühlkörper 6 keine Absenkung 10, kein Wall 11 und keine Auflagefläche 16 ausgebildet und das eine oder die mehreren weiteren Bauelemente 13 ausschließlich auf der ersten Seite 3 der Leiterplatte 2 angeordnet.

## Patentansprüche

1. Elektronische Baugruppe (1), insbesondere für ein Getriebesteuermodul, umfassend eine Leiterplatte (2) mit einer ersten Seite (3) und einer von der ersten Seite (3) abgewandten zweiten Seite (4) und mit wenigstens einem auf der ersten Seite (3) der Leiterplatte (2) angeordneten wärmeerzeugenden Bauelement (5), wobei die elektronische Baugruppe (1) weiterhin einen Kühlkörper (6) umfasst, der eine der zweiten Seite (4) der Leiterplatte (2) zugewandte Innenfläche (7) aufweist, wobei die Innenfläche (7) des Kühlkörpers (6) zumindest abschnittsweise von der Leiterplatte (2) durch wenigstens einen Spalt (8) beabstandet ist, wobei das wenigstens eine wärmeerzeugende Bauelement (5) mit einer fließfähigen und aushärtbaren Schutzmasse (9) abgedeckt ist und der wenigstens eine Spalt (8) zumindest teilweise mit der wenigstens einen fließfähigen und aushärtbaren Schutzmasse (9) derart gefüllt ist, dass die fließfähige und aushärtbare Schutzmasse (9) in direktem Kontakt zur Leiterplatte (2) und zum Kühlkörper (6) steht und der Kühlkörper (6) im ausgehärteten Zustand der fließfähigen und aushärtbaren Schutzmasse (9) stoffschlüssig an der Schutzmasse (9) anhaftet, **dadurch gekennzeichnet, dass** die Innenfläche (7) des Kühlkörpers (6) wenigstens eine Absenkung (10) aufweist, die derart ausgebildet ist, dass sie einen umlaufend von wenigstens einem Wall (11) umgebenen Grund (17) aufweist, wobei der wenigstens eine Spalt (8) durch den Abstand des Grundes (17) der Absenkung (10) und der zweiten Seite (4) der Leiterplatte (2) gebildet wird und
- dass der Wall (11) eine der zweiten Seite (4) der Leiterplatte (2) zugewandte Auflagefläche (16) aufweist, die umlaufend in direktem Kontakt zur Leiterplatte (2) steht,
- oder dass wenigstens eine der zweiten Seite (4) der Leiterplatte (2) zugewandte Abstandsfläche (19) des wenigstens einen Walls (11) durch wenigstens einen Zwischenraum (18) mit einem Abstandsmaß (B) zwischen einem Millimeter und fünfzig Mikrometern von der Leiterplatte (2) beabstandet ist, wobei der wenigstens eine Wall (11) zusätzlich wenigstens eine Auflagefläche (16) umfasst, die in direktem Kontakt zur Leiterplatte (2) steht.

2. Elektronische Baugruppe nach Anspruch 1, **dadurch gekennzeichnet, dass** auf der zweiten Seite (4) der Leiterplatte (2) wenigstens ein weiteres Bauelement (13) angeordnet ist, wobei das wenigstens eine weitere Bauelement (13) innerhalb der wenigstens einen Absenkung (10) angeordnet ist.

3. Elektronische Baugruppe nach Anspruch 1, **dadurch gekennzeichnet, dass** wenigstens eine der zweiten Seite (4) der Leiterplatte (2) zugewandte Abstandsfläche (19) des wenigstens einen Walls (11) durch wenigstens einen Zwischenraum (18) mit einem Abstandsmaß (B) zwischen einem Millimeter und fünfzig Mikrometern von der Leiterplatte (2) beabstandet ist, wobei der wenigstens eine Wall (11) vorzugsweise zusätzlich wenigstens eine Auflagefläche (16) umfasst, die in direktem Kontakt zur Leiterplatte (2) steht, und der wenigstens eine Zwischenraum (18) zumindest teilweise mit der wenigstens einen fließfähigen und aushärtbaren Schutzmasse (9) gefüllt ist.

4. Elektronische Baugruppe nach einem der Ansprüche 1 bis 3, **dadurch gekennzeichnet, dass** der wenigstens eine Wall (11) zumindest teilweise direkt unterhalb des auf der ersten Seite (3) der Leiterplatte (2) angeordneten wenigstens einen wärmeerzeugenden Bauelementes (5) oder teilweise direkt unterhalb wenigstens einer Wärmeleitschicht (14) angeordnet ist, wobei die wenigstens eine Wärmeleitschicht (14) auf der zweiten Seite (4) der Leiterplatte (2) und wenigstens teilweise direkt unterhalb des wenigstens einen wärmeerzeugenden Bauelementes (5) angeordnet ist.

5. Elektronische Baugruppe nach Anspruch 1, **dadurch gekennzeichnet, dass** der wenigstens eine Spalt (8) eine Breite zwischen der zweiten Seite (4) der Leiterplatte (2) und der Innenfläche (7) des Kühlkörpers (6) aufweist, wobei die Breite in dem gesamten Spalt (8) zwischen einem Millimeter und fünfzig Mikrometern beträgt.

6. Elektronische Baugruppe nach einem der vorhergehenden Ansprüche, **dadurch gekennzeichnet, dass** die in direktem Kontakt zu der Leiterplatte (2) und zu dem Kühlkörper (6) stehende fließfähige und aushärtbare Schutzmasse (9) einteilig mit der das wärmeerzeugende Bauelement (5) abdeckenden Schutzmasse (9) ausgebildet ist.

7. Elektronische Baugruppe nach einem der vorhergehenden Ansprüche, **dadurch gekennzeichnet, dass** die in direktem Kontakt zur Leiterplatte (2) und zum Kühlkörper (6) stehende fließfähige und aushärtbare Schutzmasse (9) über wenigstens einen in der Leiterplatte (2) ausgebildeten Durchbruch (12) einteilig mit der das wärmeerzeugende Bauelement (5) abdeckenden Schutzmasse (9) ausgebildet ist.

## Claims

1. Electronic assembly (1), in particular for a transmission control module, comprising a circuit board (2) with a first side (3) and with a second side (4) averted from the first side (3) and with at least one heat-generating component (5) arranged on the first side (3) of the circuit board (2), wherein the electronic assembly (1) furthermore comprises a cooling body (6) which has an inner surface (7) facing towards the second side (4) of the circuit board (2), wherein the inner surface (7) of the cooling body (6) is, at least in sections, spaced apart from the circuit board (2) by at least one gap (8), wherein the at least one heat-generating component (5) is covered with a flowable and curable protective compound (9), and in that the at least one gap (8) is at least partially filled with the at least one flowable and curable protective compound (9) such that the flowable and curable protective compound (9) is in direct contact with the circuit board (2) and with the cooling body (6), and in the cured state of the flowable and curable protective compound (9), the cooling body (6) cohesively adheres to the protective compound (9), **characterized in that** the inner surface (7) of the cooling body (6) has at least one recess (10) which is formed so as to have a base (17) surrounded in encircling fashion by at least one wall (11), wherein the at least one gap (8) is formed by the spacing between the base (17) of the recess (10) and the second side (4) of the circuit board (2), and
- **in that** the wall (11) has a support surface (16) which faces towards the second side (4) of the circuit board (2) and which is in direct contact, in encircling fashion, with the circuit board (2).
- or **in that** at least one spacing surface (19), which faces towards the second side (4) of the circuit board (2), of the at least one wall (11) is spaced apart from the circuit board (2) by at least one intermediate space (18) with a spacing dimension (B) of between one millimetre and fifty micrometres, wherein the at least one wall (11) additionally comprises at least one support surface (16) which is in direct contact with the circuit board (2).

2. Electronic assembly according to Claim 1, **characterized in that** at least one further component (13) is arranged on the second side (4) of the circuit board (2), wherein the at least one further component (13) is arranged within the at least one recess (10).

3. Electronic assembly according to Claim 1, **characterized in that** at least one spacing surface (19), which faces towards the second side (4) of the circuit board (2), of the at least one wall (11) is spaced apart from the circuit board (2) by at least one intermediate space (18) with a spacing dimension (B) of between one millimetre and fifty micrometres, wherein the at least one wall (11) preferably additionally comprises at least one support surface (16) which is in direct contact with the circuit board (2), and the at least one intermediate space (18) is at least partially filled with the at least one flowable and curable protective compound (9).

4. Electronic assembly according to one of Claims 1 to 3, **characterized in that** the at least one wall (11) is arranged at least partially directly below the at least one heat-generating component (5) arranged on the first side (3) of the circuit board (2), or partially directly below at least one heat-conducting layer (14), wherein the at least one heat-conducting layer (14) is arranged on the second side (4) of the circuit board (2) and at least partially directly below the at least one heat-generating component (5).

5. Electronic assembly according to Claim 1, **characterized in that** the at least one gap (8) has a width between the second side (4) of the circuit board (2) and the inner surface (7) of the cooling body (6), wherein the width amounts to between one millimetre and fifty micrometres over the entire gap (8).

6. Electronic assembly according to one of the preceding claims, **characterized in that** the flowable and curable protective compound (9) which is in direct contact with the circuit board (2) and with the cooling body (6) is formed in one piece with the protective compound (9) which covers the heat-generating component (5) .

7. Electronic assembly according to one of the preceding claims, **characterized in that** the flowable and curable protective compound (9) which is in direct contact with the circuit board (2) and with the cooling body (6) is formed in one piece, via at least one aperture (12) formed in the circuit board (2), with the protective compound (9) which covers the heat-generating component (5) .

## Revendications

1. Module électronique (1), en particulier pour un module de commande de transmission, comprenant une carte de circuit imprimé (2) ayant un premier côté (3) et un deuxième côté (4) opposé au premier côté (3) et au moins un composant générateur de chaleur (5) disposé sur le premier côté (3) de la carte de circuit imprimé (2), dans lequel le module électronique (1) comprend également un élément de refroidissement (6) qui présente une surface intérieure (7) faisant face au deuxième côté (4) de la carte de circuit imprimé (2), dans lequel la surface intérieure (7) de l'élément de refroidissement (6) est séparée au moins en partie de la carte de circuit imprimé (2) par au moins un espace (8), dans lequel ledit au moins un composant générateur de chaleur (5) est recouvert d'une masse de protection (9) fluide et durcissable et ledit au moins un espace (8) est au moins en partie rempli de ladite au moins une masse de protection (9) fluide et durcissable de manière à ce que la masse de protection (9) fluide et durcissable soit en contact direct avec la carte de circuit imprimé (2) et avec l'élément de refroidissement (6), et que l'élément de refroidissement (6) adhère par liaison de matière à la masse de protection (9) lorsque la masse de protection (9) fluide et durcissable est durcie, **caractérisé en ce que** la surface intérieure (7) de l'élément de refroidissement (6) présente au moins un creux (10) qui est conçu de manière à ce qu'il présente un fond (17) entouré d'au moins une paroi (11), dans lequel ledit au moins un espace (8) est formé par la séparation entre le fond (17) du creux (10) et le deuxième côté (4) de la carte de circuit imprimé (2) et
- **en ce que** la paroi (11) présente une surface d'appui (16) faisant face au deuxième côté (4) de la carte de circuit imprimé (2), qui est en contact direct circonférentiellement avec la carte de circuit imprimé (2),
- ou **en ce qu'**au moins une surface de séparation (19) de ladite au moins une paroi (11), faisant face au deuxième côté (4) de la carte de circuit imprimé (2) est séparée de la carte de circuit imprimé (2) par au moins un espace intermédiaire (18) ayant une dimension de séparation (B) comprise entre un millimètre et cinquante micromètres, dans lequel ladite au moins une paroi (11) comprend en outre au moins une surface d'appui (16) qui est en contact direct avec la carte de circuit imprimé (2).

2. Module électronique selon la revendication 1, **caractérisé en ce qu'**au moins un autre composant (13) est disposé sur le deuxième côté (4) de la carte de circuit imprimé (2), dans lequel ledit au moins un autre composant (13) est disposé à l'intérieur dudit au moins un creux (10).

3. Module électronique selon la revendication 1, **caractérisé en ce qu'**au moins une surface de séparation (19) de ladite au moins une paroi (11) faisant face au deuxième côté (4) de la carte de circuit imprimé (2) est séparée de la carte de circuit imprimé (2) par au moins un espace intermédiaire (18) ayant une dimension de séparation (B) comprise entre un millimètre et cinquante micromètres, dans lequel ladite au moins une paroi (11) comprend en outre de préférence au moins une surface d'appui (16) qui est en contact direct avec la carte de circuit imprimé (2), et ledit au moins un espace intermédiaire (18) est au moins en partie rempli de ladite au moins une masse de protection (9) fluide et durcissable.

4. Module électronique selon l'une des revendications 1 à 3, **caractérisé en ce que** ladite au moins une paroi (11) est disposée au moins en partie directement en dessous dudit au moins un composant générateur de chaleur (5) disposé sur le premier côté (3) de la carte de circuit imprimé (2) ou en partie directement en dessous d'au moins une couche conductrice de chaleur (14), dans lequel ladite au moins une couche conductrice de chaleur (14) est disposée sur le deuxième côté (4) de la carte de circuit imprimé (2) et au moins en partie directement en dessous dudit au moins un composant générateur de chaleur (5) .

5. Module électronique selon la revendication 1, **caractérisé en ce que** ledit au moins un espace (8) présente une largeur comprise entre le deuxième côté (4) de la carte de circuit imprimé (2) et la surface intérieure (7) de l'élément de refroidissement (6), dans laquelle la largeur de l'espace (8) total est comprise entre un millimètre et cinquante micromètres.

6. Module électronique selon l'une des revendications précédentes, **caractérisé en ce que** la masse de protection (9) fluide et durcissable, qui est en contact direct avec la carte de circuit imprimé (2) et avec l'élément de refroidissement (6), est formée d'un seul tenant avec la masse de protection (9) recouvrant le composant générateur de chaleur (5).

7. Module électronique selon l'une des revendications précédentes, **caractérisé en ce que** la masse de protection (9) fluide et durcissable en contact direct avec la carte de circuit imprimé (2) et avec l'élément de refroidissement (6) est formée d'un seul tenant avec la masse de protection (9) recouvrant le composant générateur de chaleur (5) par l'intermédiaire d'au moins une traversée (12) ménagée dans la carte de circuit imprimé (2).
